# EUROPÄISCHE PATENTSCHRIFT

(11) **EP 0 762 822 B1**
(45) Veröffentlichungstag und Bekanntmachung des Hinweises auf die Patenterteilung: **20.05.1998**
(21) Anmeldenummer: 96112098.7
(22) Anmeldetag: 25.07.1996
(51) Int. Cl.: H05K 9/00

(54) **Vorrichtung zur Masseverbindung einer Flachbaugruppe**
Device for grounding a circuit board module
Dispositif pour la mise en terre d'un module de plaque de circuit imprimé

(30) Priorität: 24.08.1995 DE 19531207
(43) Veröffentlichungstag der Anmeldung: 12.03.1997
(73) Patentinhaber: Siemens Nixdorf Informationssysteme AG, 33106 Paderborn (DE)
(72) Erfinder: Hegel, Horst, 85247 Schwabhausen (DE)
(74) Vertreter: Fuchs, Franz-Josef, Dr.-Ing.

(56) Entgegenhaltungen:
- DE-A- 3 328 395
- DE-C- 3 500 362
- US-A- 5 138 529
- IBM TECHNICAL DISCLOSURE BULLETIN, Bd. 38, Nr. 2, 1.Februar 1995, Seite 387/388 XP000502514 "SNAP-IN PLANAR ELECTROMAGNETIC COMPATIBILITY GROUNDING STANDOFF"

## Beschreibung

Die Erfindung betrifft eine Vorrichtung gemäß den Merkmalen des Oberbegriffs des Anspruchs 1.

Flachbaugruppen, beispielsweise sog. Systemboards von Personalcomputern, müssen an den Masseanschlüssen aus Gründen der elekromagnetischen Abschirmung gut leitend mit dem auf Massekontakt liegenden Gehäuse verbunden werden. Üblicherweise geschieht dies dadurch, daß die Flachbaugruppe bzw. das Systemboard an mehreren Stellen mit dem Gehäuse verschraubt werden, wobei die Schrauben zusätzlich auch zur mechanischen Befestigung dienen.

Da insbesondere Systemboards von Personalcomputern in zunehmendem Maße mittels Rast- oder Schnapphaken mechanisch befestigt werden, die Schraubverbindung aber wegen des Massekontakts zum Gehäuse nach wie vor erforderlich ist, bedeutet dies letztlich keinen besonderen Vorteil bei der Montage.

Aus US 5,218,760 und JP 2-250 276 A sind bereits streifenförmige Kontaktfederelemente bekannt, die so geformt sind, daß sie einerseits in Durchbrechungen der Flachbaugruppe rastend eintauchen und andererseits federnd zwischen Flachbaugruppe und Gehäusewandung eingespannt sind. Auf Grund der relativ geringen Breite und der, bedingt durch die spezielle Form der streifenförmigen Kontaktfedern, kleinen Kontaktflächen, ergibt sich nur ein mäßiger Massekontakt zwischen der Flachbaugruppe und der Gehäusewandung. Außerdem verfügen diese schmalen Kontaktfedern nur über eine sehr geringe Seitenstabiltität.

Der vorliegenden Erfindung liegt deshalb die Aufgabe zugrunde, für den Masseanschluß von Flachbaugruppen, insbesondere von Systemboards von Personalcomputern, mit Hilfe von Kontaktfedern und damit unter Verzicht auf Schraubenkontakte, einen möglichst guten und sicheren Kontakt herzustellen

Erfindungsgemäß wird diese Aufgabe, ausgehend von einer Vorrichtung der eingangs genannten Art, durch die kennzeichnenden Merkmale des Anspruchs 1 gelöst. Vorteilhafte Weiterbildungen der Erfindung sind in Unteransprüchen angegeben.

Im folgenden wird ein Ausführungsbeispiel der Erfindung anhand der Zeichnung näher erläutert. Dabei zeigen
- Figur 1: eine erfindungsgemäße Vorrichtung in Draufsicht,
- Figur 2: eine Schnittdarstellung der Vorrichtung gemäß Figur 1 längs der Schnittlinie II-II,
- Figur 3: die erfindungsgemäße Vorrichtung in funktionsgerechtem Einbau.

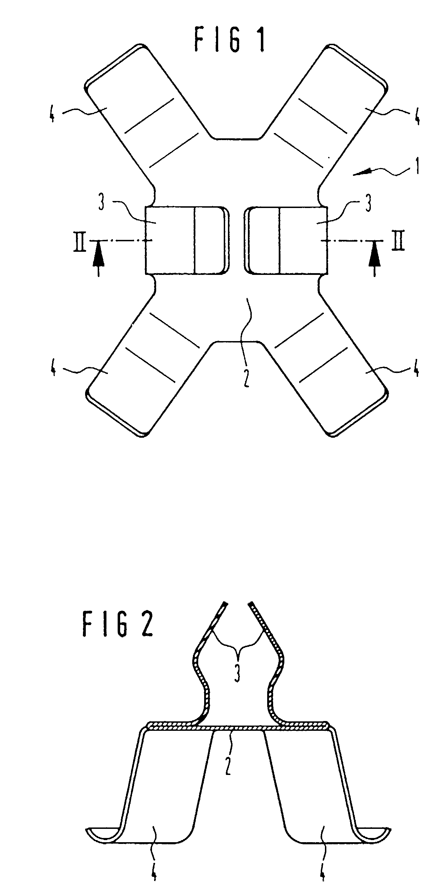

Die Figur 1 zeigt ein Kontaktfederelement 1, das, ausgehend von einer zentralen Stützfläche 2, mehrere strahlenförmig angeordnete Kontaktlaschen 3,4 aufweist. Zwei einander diametral gegenüber angeordnete Kontaktlaschen 3 sind gekröpft und an den Enden hochgebogen. Die übrigen Kontaktlaschen 4 sind, bezogen auf die Stützfläche 2, in entgegengesetzter Richtung abgewinkelt und bilden jeweils Stützfüße.

Die durch die Abwinkelung der Kontaktlaschen 3,4 sich ergebende Form für das Kontaktfederelement 1 wird anhand der Schnittdarstellung in Figur 2 deutlicher erkennbar. Diese Figur 2 zeigt die Stützfläche 2 mit den zwei gekröpften und hochgebogenen Kontaktlaschen 3, die im hochgebogenen Bereich eine konvexähnliche Form aufweisen und mit ihren Enden einander zugewandt sind. Die als Stützfüße dienenden Kontaktlaschen 4 sind schräg nach unten abgewinkelt und an den Enden bogenförmig nach außen gerichtet.

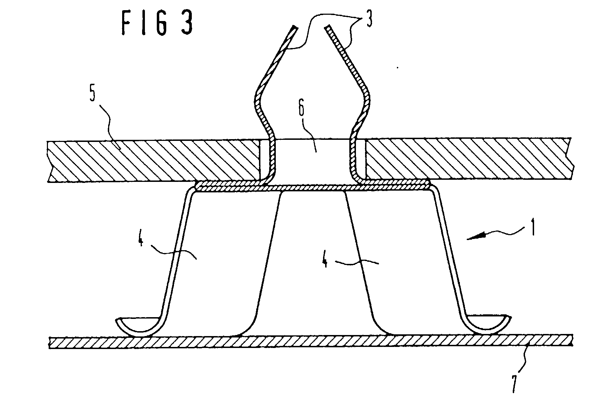

In der Figur 3 ist die Vorrichtung gemäß den Figuren 1 und 2 in eingebautem Zustand dargestellt. Sie zeigt einen Ausschnitt aus einer Flachbaugruppe 5, insbesondere aus einem sog. Systemboard, mit einer standardmäßig vorgegebenen Befestigungsbohrung 6. Der Massekontakt zwischen Flachbaugruppe 5 und einer im Abstand dazu angeordneten metallischen Gehäusewandung 7 erfolgt durch mehrere Kontaktfederelemente 1, die vorzugsweise einstückig aus einem gestanzten Federblech gefertigt sind.

Beim Aufsetzen der Flachbaugruppe 5 taucht das Kontaktfederelement 1 mit den beiden Kontaktlappen 3 soweit in die Befestigungsbohrung 6 ein, bis die Flachbaugruppe 5 auf der Stützfläche 2 des Kontaktfederelements 1 aufliegt. Durch die konvexe Form der beiden Kontaktlappen 3 wird die Flachbaugrupe in der unmittelbar über der Stützfläche 2 vorgesehenen Einschnürung rastend gehalten. An der Unterseite der Flachbaugruppe 5 wird das Kontaktfederelement 1 zwischen Flachbaugruppe 5 und der metallischen Gehäusewandung 7 eingespannt, wobei sich die Kontaktlappen 4 federnd an der Gehäusewandung 7 abstützen. Um bei der Montage die Flachbaugruppe 7 verschieben zu können, sind die Stützfüße, auch im Hinblick auf eine gute Kontaktierung, an ihren Enden nach außen leicht hochgebogen. Vorzugsweise besteht das Kontaktfederelement aus einem einzigen Teil. Es sind aber auch zweiteilige Ausführungsformen denkbar. Die durch das Rastelement gebildete Schnappverbindung kann gegebenenfalls durch eine Lötverbindung ergänzt bzw. verstärkt werden.

## Patentansprüche

1. Vorrichtung zur Masseverbindung einer im Abstand zu einer elektrisch leitenden Gehäusewandung angeordneten Flachbaugruppe, die an mehreren Stellen mittels am Gehäuse angeordneter Rast- bzw. Schnappkanten mechanisch gehalten ist, unter Verwendung von Kontaktfederelementen, die an den jeweils Durchbrechungen in der Flachbaugruppe aufweisenden Masseanschlüssen zwischen Gehäusewandung und Flachbaugruppe federnd eingespannt sind,
**dadurch gekennzeichnet,**
daß das Kontaktfederelement (1) aus einer Stützfläche (2) mit mehreren strahlenförmig, ringsum verteilt angeordneten Kontaktlaschen (3,4) besteht, von denen zwei diametral einander gegenüberliegend angeordnete Kontaktlaschen (3) gekröpft und an den einander zugewandten Enden hochgebogen, ein in die Durchbrechung der Flachbaugruppe (5) eintauchendes Rastelement bilden, während die übrigen Kontaktlaschen (4) als zwischen Flachbaugruppe (5) und Gehäusewandung (7) federnd eingespannte Stützfüße dienen.

2. Vorrichtung nach Anspruch 1,
**dadurch gekennzeichnet,**
daß die das Rastelement bildenden Kontaktlaschen (3) an den hochgebogenen Enden, ausgehend von einer unmittelbar über der Stützfläche (2) vorgesehenen Einschnürung, eine konvexartig nach außen gerichtete Wölbung aufweisen.

3. Vorrichtung nach Anspruch 1 oder 2,
**dadurch gekennzeichnet,**
daß die Enden der als Stützfüße dienenden Kontaktlaschen (4) bogenförmig auslaufen.

## Claims

1. Apparatus for earth connection of a printed circuit board assembly which is arranged at a distance from an electrically conductive housing wall and is mechanically held at a plurality of points by means of latching and/or snap-action edges arranged on the housing, using contact spring elements which are clamped in between the housing wall and the printed circuit board assembly in a sprung manner at the earth connections, which in each case have knock-outs in the printed circuit board assembly, characterized in that the contact spring element (1) comprises a supporting surface (2) having a plurality of contact lugs (3, 4) which are arranged in the form of rays and are distributed all round, and of which two contact lugs (3) which are arranged diametrically opposite one another, cranked and bent up at the mutually facing ends, form a latching element which enters the knock-out in the printed circuit board assembly (5), while the other contact lugs (4) are used as supporting feet which are clamped in in a sprung manner between the printed circuit board assembly (5) and the housing wall (7).

2. Apparatus according to Claim 1, characterized in that the contact lugs (3) which form the latching element have a bulge which points outwards in a convex manner at the bent-up ends, originating from a constriction which is provided immediately above the supporting surface (2).

3. Apparatus according to Claim 1 or 2, characterized in that the ends of the contact lugs (4), which are used as supporting feet, end in the form of an arc.

## Revendications

1. Dispositif pour la mise à terre d'un module de plaque de circuit imprimé disposé à distance d'une paroi de boîtier électroconductrice, maintenu mécaniquement en plusieurs endroits au moyen de bords à déclic ou de fixation disposés sur le boîtier, en utilisant des éléments élastiques de contact qui sont serrés de manière élastique entre la paroi de boîtier et le module de plaque de circuit imprimé sur les connecteurs de terre présentant chacun des percées dans le module de plaque de circuit imprimé,
**caractérisé en ce que**
l'élément élastique de contact (1) est composé d'une surface d'appui (2) avec plusieurs languettes de contact (3,4) distribuées de manière radiale et périphérique, dont deux languettes de contact (3) disposées diamétralement en regard l'une de l'autre, coudées et courbées vers le haut aux extrémités se faisant face, forment un élément de fixation plongeant dans la percée du module de plaque de circuit imprimé (5), tandis que les autres languettes de contact (4) servent de pattes d'appui serrées de manière élastique entre le module de plaque de circuit imprimé (5) et la paroi de boîtier (7).

2. Dispositif selon la revendication 1,
**caractérisé en ce que**
les languettes de contact (3) qui forment l'élément de fixation présentent, aux extrémités courbées vers le haut, en partant d'un rétrécissement prévu directement au-dessus de la surface d'appui (2), une voûte de type convexe dirigée vers l'extérieur .

3. Dispositif selon la revendication 1 ou 2,
**caractérisé en ce que**
les extrémités des languettes de contact (4) servant de pattes d'appui se terminent de manière courbe.
